# EUROPEAN PATENT SPECIFICATION

(11) **EP 2 270 253 B1**
(45) Date of publication and mention of the grant of the patent: **12.09.2012**
(21) Application number: 09164593.7
(22) Date of filing: 03.07.2009
(51) Int. Cl.: C23C 14/54, C23C 14/22, B21F 1/00, B21F 99/00

(54) **Bending fixture for homogenous and smooth operation of an evaporation source**
Biegevorrichtung für homogenen und reibungslosen Betrieb einer Verdampfungsquelle
Appareil de flexion pour le fonctionnement homogène et lisse d'une source d'évaporation

(43) Date of publication of application: 05.01.2011
(73) Proprietor: Applied Materials, Inc., Santa Clara, CA 95054 (US)
(72) Inventor: Keller, Stefan, 63814 Mainaschaff (DE); Bruch, Juergen, 61130 Nidderau (DE); Klemm, Guenter, 63667 Nidda (DE); Keim, Karl-Albert, 63654 Buedingen (DE); Hein, Stefan, 63825 Blankenbach (DE)
(74) Representative: Zimmermann & Partner

(56) References cited:
- GB-A- 1 569 358
- JP-A- 7 286 266
- JP-A- 60 211 071
- US-A- 3 860 444

## Description

### FIELD OF THE INVENTION

Embodiments of the present disclosure relate to an evaporation apparatus and method. In particular, they relate to an evaporation apparatus having a bending fixture.

### BACKGROUND OF THE INVENTION

Evaporation sources can be used for coating a substrate with a thin film of material. For example, coatings of metal films on organic light-emitting diodes (OLEDs) can be applied with evaporation sources. OLEDs are a special type of light-emitting diodes in which the emissive layer comprises a thin-film of certain organic compounds. OLEDs can be used in television screens, portable screens, computer displays, and so on. The functionality of OLEDs depends on the thickness of the coating. This thickness has to be within a predetermined range and to be steady over time.

In order to evaporate material it is known in the art to use a heated evaporation structure. The material which will be evaporated is fed to the heated evaporation structure often in the form of a wire. The wire to be fed is often wound up on a coil. The wire to be fed can have different curvatures.

US 3,860,444 A is directed at the coating of work pieces by vapor deposition in a vacuum chamber. A bath is in a crucible which is held in a molten state by electron bombardment From an electron gun in order to maintain it at vaporization temperature. A wire is fed continuously into the chamber.

JP 60 211071 is about a vacuum depositing apparatus. A metallic wire is unwound from a bobbin and supplied to an evaporation source to be heated and evaporated through a guide pipe by means of rotation of driving rollers. The wire is received with plastic hysteresis because it has been wound on the bobbin. The plastic hysteresis is removed through a leveler consisting of plural rollers.

JP 07 286266 A is about a vapor deposition device. The goal is to provide a vapor deposition with the resulting film thickness distribution to be highly uniform. The wire 16 is continuously fed to the crucible. The crucible forms a bath of the material.

### SUMMARY OF THE INVENTION

In light of the above, a bending fixture, an evaporation apparatus, a method of giving a wire a reproducible curvature, a method for evaporating material and a method for depositing a layer on a substrate is provided. The evaporation apparatus according to the invention and the method for evaporating a wire according to the invention are defined in claims 1 and 8, respectively.

According to an aspect, an evaporation apparatus for coating a substrate is provided. The evaporation apparatus includes an evaporation structure for evaporating material. The evaporation structure has an evaporation structure surface for receiving a wire. The evaporation apparatus further includes a wire feed for providing the wire and a bending fixture. The bending fixture is capable of giving the wire a reproducible curvature so that in operation the contact area of the wire on the evaporation structure is at a desired position. The bending fixture comprises a first and a second roller for guiding the wire, wherein the second roller is movable with respect to the first roller. The evaporation apparatus further includes an electric motor for moving the at least one movable roller and/or an electric motor for moving the bending fixture.

The term "desired position" as used herein may be understood as including a deviation of 3 mm at maximum, more typically 1.5 mm at maximum from the exactly desired position. For instance, the phrase "the contact spot of the wire on the evaporation structure is at a desired position" may be understood in that the wire's center contacts the evaporation structure always at the identical position on the evaporation structure with typically plus/minus maximally 3 mm tolerance as measured from the wire's center. In many embodiments, the desired position on the evaporation structure is a constant position. Typically, it does therefore not change over time. The phrase "does not change over time" may be understood as including a deviation of 3 mm at maximum, more typically 1.5 mm at maximum.

According to an aspect, a method for evaporating a wire is provided. The method includes guiding the wire through a bending fixture having a first and a second roller, with the second roller being movable with respect to the first roller, thereby giving the wire a reproducible curvature so that the contact spot of the wire on the evaporation structure is at a desired position; directing the wire to an evaporation structure for evaporation; moving the movable second roller and/or the bending fixture by means of an electric motor such that the contact point of the wire on the evaporation structure changes steadily over time; and evaporating the wire.

Further effects, features, aspects and details that can be combined with the above embodiments are evident from the dependent claims, the description and the drawings.

Embodiments are also directed to apparatuses for carrying out the disclosed methods and include apparatus parts for performing the described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

Some of the above indicated and other more detailed aspects of the invention will be described in the following description and partially illustrated with reference to the figures. Therein:
- Figure 1: shows a side-view of the bending fixture according to embodiments described herein;
- Figure 2: shows a cross-sectional view of embodiments of the bending fixture indicated by section B-B in Figure 1;
- Figure 3: shows a cross-sectional view of embodiments of the bending fixture indicated by section A-A in Figure 2;
- Figure 4A: shows a schematic view of an evaporation apparatus for vapor deposition of a thin film on a substrate according to embodiments described herein;
- Figure 4B: shows a schematic view of an evaporation apparatus for vapor deposition of a thin film on a substrate according to embodiments described herein;
- Figure 5A: shows embodiments of the bending fixture in a schematic three-dimensional view;
- Figure 5B: shows embodiments of the bending fixture driven by an electric motor in a schematic three-dimensional view
- Figure 6: shows embodiments of the bending fixture wherein the multitude of rollers consists of five rollers;
- Figure 7: shows embodiments of the bending fixture wherein the multitude of rollers consists of five rollers.

### DETAILED DESCRIPTION OF THE DRAWINGS

Within the following description of the drawings, the same reference numbers refer to the same components. Generally, only the differences with respect to the individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Within the following description, the term "evaporation structure" shall refer to an evaporation unit capable of evaporating an evaporation material for coating a substrate with the evaporation material. Typical evaporation structures comprise crucibles, evaporation boats, etc. The evaporation surface structure may be planar, pointed, or may be provided with a recess. The evaporation material is the material that is evaporated during the evaporation and with which the substrate is coated.

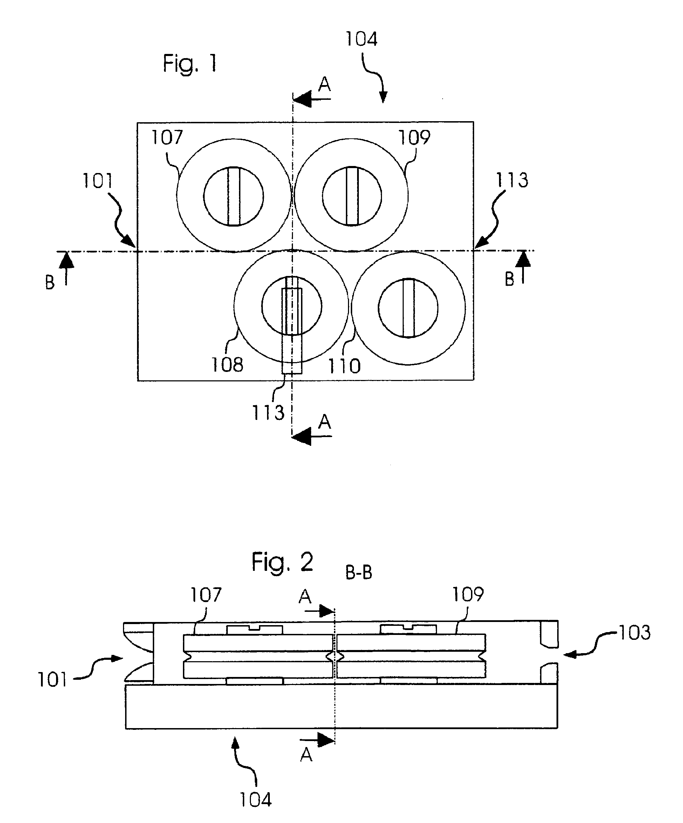

Figure 1 shows embodiments of a bending fixture with four rollers. The bending fixture 104 has a first opening 101 for feeding a wire into the device and a second opening 103 for allowing the wire to exit the bending fixture. The first opening 101 is also called "entrance opening". The second opening 103 is also called "exit opening". The bending fixture 104 illustrated in Fig. lincludes at least four rollers 107, 108, 109, 110. Furthermore, for easier reference, an "entrance-exit line" shall be defined as the straight line from the center of the entrance opening 101 to the center of the exit opening 103. The bending fixture includes a first side of the entrance-exit line and a second side of the entrance-exit line which is opposite to the first side of the entrance-exit line.

A "roller" as used herein is capable of guiding a wire and may include a roll, a cylinder, a drum, a roller bearing, a ball bearing and the like.

Typically, the rollers are provided in one plane on the first and second side of the entrance-exit line. In the embodiment of Fig. 1, four of these rollers are situated at different positions along the entrance-exit line. The roller arrangement as described herein typically gives the wire a constant and reproducible curvature. The roller 107 with the closest distance to the first opening along the entrance-exit line is situated on the first side of the entrance-exit line, the roller 108 with the second closest distance to the first opening along the entrance-exit line is situated on the second side of the entrance-exit line, the roller 109 with the third closest distance to the first opening along the entrance-exit line is situated on the first side of the entrance-exit line and the roller 110 with the fourth closest distance to the first opening along the entrance-exit line is situated on the second side of the entrance-exit line. Typically, the curvature of the wire after exiting the bending fixture 104 has a bending radius in the range of between infinity (i.e. no bending at all) and 40 mm, more typically between 100 mm and 300 mm such as 200 mm. Typically, the material of the rollers is harder than the material of the fed wire.

For the purpose of a simpler description, the rollers are numbered consecutively in the order they get in contact with the fed wire. The roller with the closest distance to the entrance opening along the entrance-exit line is called the first roller. The roller with the second closest distance to the entrance opening along the entrance-exit line is called the second roller to; and so forth.

According to embodiments, at least one roller is not fixedly mounted on the bending fixture. Typically, this at least one roller is movable in the direction perpendicular to the fed wire and can be fixed at different positions. In embodiments, at least the second roller is movable perpendicularly to the direction of the fed wire.

In order to allow the roller to move, the bending fixture comprises a roller moving device such as a rail, a pivotable screw or the like. For instance, as shown in Fig. 1, the at least one movable roller 108 can be moved along a roller moving device 113 that may include a rail. The at least one movable bearing 108 can be fixed in at least one position, typically at different positions along the rail 113. The movement is typically done manually. Due to the fact that the bending device as described herein guarantees that the exiting wire has a reproducible bending radius independent from the bending radius of the entering wire, it is no longer necessary that the bending radius is checked once a new coil of wire is used. The position of the movable roller is therefore typically only amended if a different bending radius of the exiting wire is desired.

In other embodiments, the roller is moved electrically, for instance in those embodiments in which it is desired to have a continuous movement of the wire end on the evaporation structure during evaporation. Generally, the constant speed of movement guarantees a constant evaporation rate. Moving the roller in a predetermined way allows the wire to contact the evaporation structure surface at along a desired and typically predetermined route. Hence, at each point in time, the wire contacts the evaporation structure at a desired position.

In typical embodiments, the bending fixture includes a device for allowing the at least one movable bearing to move and for fixing the at least one movable bearing. The at least one movable roller 108 can typically be moved perpendicularly to the direction of the fed wire up to a maximum of 15 mm, more typically a maximum of 13 mm away from the entrance-exit line. The distances given refer to the distance as measured from the center of the roller. For instance, if the roller has a radius of 10 mm, the term "a maximum of 15 mm away from the entrance-exit line" could be used synonymously to "the distance between entrance-exit line and the outer perimeter of the roller is a maximum of 5 mm". The typical radius of the roller is between 8 mm and 12 mm, more typically between 9 mm and 11 mm such as 10.85 mm.

According to embodiments, the majority of the rollers, i.e. more than half of the total, are fixedly mounted on the bending fixture. In some embodiments, all but one of the rollers are fixedly mounted on the bending fixture.

The distance along the direction of the fed wire between two fixedly mounted rollers on the same side of the wire is typically between 20 mm and 30 mm, more typically between 21 mm and 23 mm. The distance between two fixedly mounted rollers perpendicular to the direction of the fed wire is typically between 15 mm and 25 mm.

For instance, it is typical that the first, second, and/or fourth roller have a distance to the center-exit line that is approximately identical to the radius. In other words, the center-exit line is a kind of tangent to the perimeter of the roller. "Approximately" is to be understood as typically including a deviation of not more than 1mm. According to embodiments, the second roller can be moved such that the distance between the roller and the center-exit line can be varied in a range of the roller radius plus/minus a maximum of 3 mm, more typically a maximum of 2 mm. The larger the distance deviates from the radius, the larger the bending radius of the exiting wire.

Typically, the rollers are grooved rollers. According to embodiments, the rollers are vacuum suited grooved rollers. Typically, the groove has a V-shape with a typical height of between 1 and 3 mm; and a typical width of between 1 and 3 mm. The V-shape provides for a two-point contact between roller and wire (as seen from a cross-sectional view) and thus guarantees an exact guiding of the wire.

A wire that is fed through the bending fixture 104 has a desired curvature when exiting the bending fixture 104, no matter if and what curvature the wire had when entering the bending fixture. By placing the rollers at the same positions, the curvature of the wire when exiting the bending fixture 104 is reproducible. The curvature of the exiting wire can be changed by changing the position of the at least one movable roller.

Figure 2 shows a cross-sectional view of embodiments of the bending fixture 104 indicated by section B-B in Figure 1; i.e. Figure 2 shows what can be seen in one direction, if one is located on the line B-B in Figure 1. Two rollers 107, 109 of the rollers can be seen in Figure 2. The radius of the rollers is typically in the range of between 8 mm and 12 mm. The height of the rollers is typically in the range of between 6 mm to 9 mm. Typically, the recess of the rollers for the fed wire has a width between 1 mm and 3 mm. The depth of the recess of the rollers for the fed wire is typically 1.5 mm and 4 mm. Generally, the rollers themselves are identical to each other. The fed wire typically has a radius of between 0.5 mm and 2 mm, more typically between 0.5 mm and 1mm.

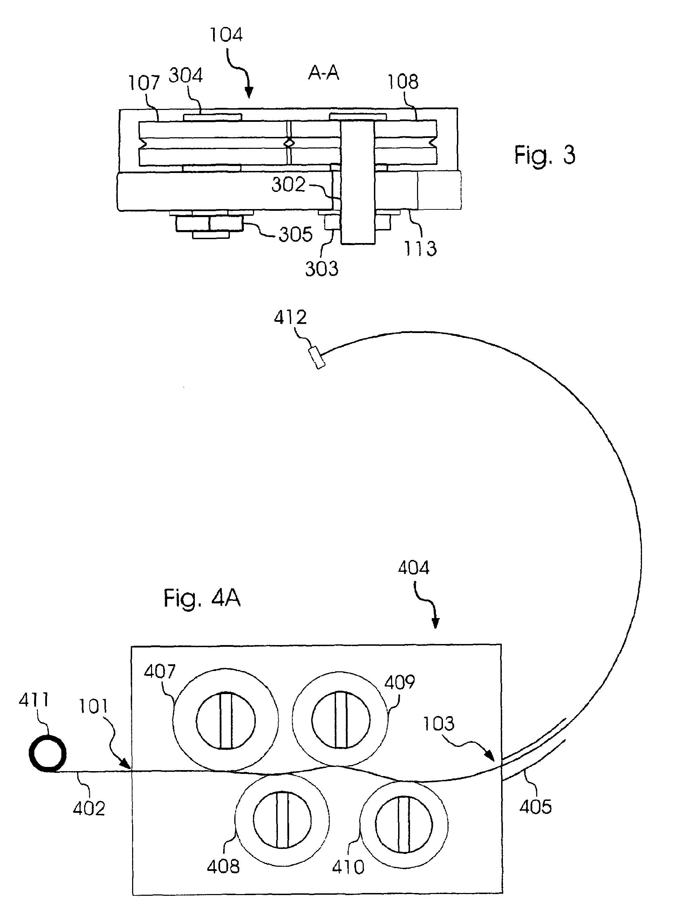

Figure 3 shows a cross-sectional view of embodiments of the bending fixture indicated by section A-A in Figure 2; i.e. Figure 3 shows what can be seen in one direction, if one is located on the line A-A in Figure 1 or Figure 2. Two of the rollers 107, 108 can be seen in Figure 3.

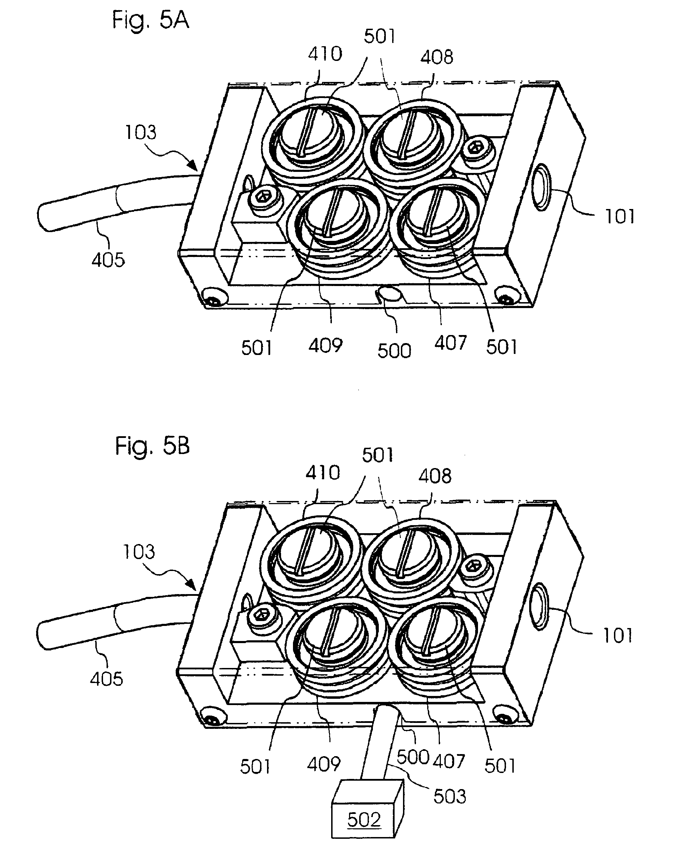

Typically, each of the movable rollers is attached to the bending fixture 104 with a bolt 302 and a nut 303. Typically each of the rollers is attached to the bending fixture 104 with by means of a fixture unit, such as a bolt 304 and a nut 305. Alternatively, they are attached by means of a screw 501 (see Figs. 5A and 5B) that may also cooperate with a nut.

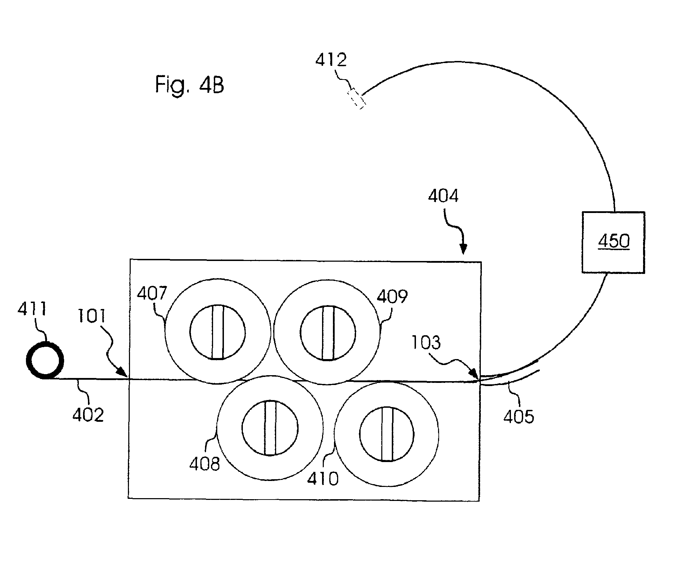

Figures 4A and 4B show embodiments of the bending fixture within an evaporation apparatus. It is to be noted that the drawings are not true to scale. The wire 402 is fed from a wire feed 411. In the embodiment of Fig. 4A, the wire feed 411 is shown as a coil on which the wire is wound up. The unrolled wire 402 is fed into the bending fixture 404 through the first opening 101.

In typical embodiments of the present disclosure, the rollers have a wire contact surface for contacting the wire with the rollers being positioned and oriented such that the guiding surfaces of the rollers span a two-dimensional space. The wire contact surface may be, for instance, a recess such as a groove placed on the outer surface of the rollers with the wire being supposed to contact the roller in the groove.Typically, the wire is guided in this two-dimensional space.

Generally, in embodiments of the bending fixture a guiding unit such as conduit 405 is attached to the second opening 103 of the bending fixture 404. In embodiments, the wire exits the bending fixture through the second opening 403 and enters an attached conduit 405. In typical embodiments, the conduit is bent. In some embodiments, the guiding unit is bent in the plane in which the rollers are located.

The angle between the exit of the bent conduit 405 and the entrance-exit line of the bending fixture 404 is typically between 0° and 30°, more typically between 15° and 20°. The typical bending radius is in the range of between infinity (i.e. no bending at all) and 40 mm, more typically between 100 mm and 300 mm such as 200 mm. Typically the conduit is bent away from the at least one movable roller.

The conduit may be made of stainless steel, copper or the like. According to embodiments, the conduit has a length of between 20 mm and 80 mm, typically between 40 mm and 60 mm. The inner mean diameter of the conduit is larger than the wire diameter, typically between 3 mm and 5 mm, more typically between 3.5 mm and 4.5 mm.

Typically, the wire can be used as evaporation material for an evaporation unit such as an evaporation structure 412.

After the wire 402 exits the bending fixture 404 and/or the conduit 405, the wire 402 typically is fed to an evaporation structure 412. In typical embodiments of the present disclosure, the wire 402 goes through an angle after exiting the bending fixture 404 before the wire gets in contact with the evaporation structure. Typically, the wire 402 contacts the evaporation structure 412 in an angle of between 30° and 90° (i.e. the angle between the evaporation structure surface at the contact point and the wire). The angle that the wire goes through is typically between 150° and 210°, more typically between 165° and 195°, such as 180°. In this regard, it is to be noted that the bending fixture generally has to be thermally isolated from the evaporation structure which is, during operation, at temperatures of more than 1,000°C such as 1,400°C or even 1,600°C. It might therefore be desired to place the evaporation structure as far away from the bending fixture as possible. Angles in the range of 180° that the wire goes through allow a maximal distance (at a given radius).

In addition, according to embodiments, a wire feed 450 is positioned typically between bending fixture and evaporation structure. If the wire feed is positioned downstream of the bending fixture, i.e. between the bending fixture and the evaporation structure, it pulls the wire through the bending fixture and pushes the wire towards the evaporation structure.

According to embodiments, the present disclosure allows also a constant movement of the wire along the evaporation structure surface thereby avoiding massive spot-wise corrosion of the evaporation structure. When moving the wire over the evaporation structure, it is important for a constant evaporation rate to guarantee a constant moving speed. For instance, if the wire is moved in an unsteady, abrupt way, the following happens.

Generally, the wire, which melts when it contacts the heated evaporation structure, diffuses into the evaporation structure at the contact point of the wire, so there is also a kind of memory effect in the evaporation structure in respect of the contact point of the wire. If the bending curvature of the wire that is fed to the evaporation structure changes, the contact point of the wire on the evaporation structure changes from a first contact point to a second contact point. When this happens abruptly, the second contact point on the evaporation structure is not moistened by the melted wire material beforehand, i.e. the melted wire has not diffused into the evaporation structure yet.

Additionally to the melted wire at the second contact point, remnants of the melted wire, which have diffused into the evaporation structure at the first contact point, evaporate simultaneously. Thus, the evaporation rate increases above the normal constant rate over a period of time.

Furthermore, the melted wire at the second point starts to diffuse into the evaporation structure. However, the diffusion of the melted wire into the evaporation structure at the second point takes longer than the complete evaporation of the remnants of the melted wire at the first point.

After a period of time, the remnants of the melted wire at the first contact point have evaporated completely, i.e. no material to evaporate is left at the first contact point, while melted wire continues to diffuse into the evaporation structure at the second point. Thus, the evaporation rate then decreases below the normal constant rate. After the melted wire has fully moistened the evaporation structure at the second contact point, the evaporation rate increases to its normal constant rate again.

Changes in the evaporation rate lead to different thicknesses of the coating on the substrate or substrates, which are processed at the same time, or on substrates, which are processed in succession. Therefore, changes in the evaporation rate are undesirable.

The bending curvature of the wire to be fed can change over time. So it has often been necessary to readjust the complete wire feed. Particularly when the wire to be fed is wound up on a coil, the bending curvature of the wire can change from lot-to-lot or within the wire.

By providing a bending fixture for giving the wire a reproducible curvature, the contact point of the wire and the evaporation structure typically remains the desired one, no matter if and what curvature the wire had when entering the bending fixture. Typically, the contact point is constant over time. Thus the contact point on the evaporation structure is always moistened. This leads to stable and reproducible evaporation conditions resulting in constant evaporation rate and thickness homogeneity over time.

Further, uncontrolled changes of the contact point of the wire and the evaporation structure can lead to feeding the wire to a point outside of the evaporation structure area or to a point on an unwanted side of the evaporation structure.

The precise reproducible preset curvature of the wire exiting the bending fixture guarantees that the contact point of the wire and the evaporation structure remains at the desired position over time. Thus, feeding the wire to an unwanted point on the evaporation structure or even to a point outside of the evaporation structure is avoided.

In embodiments where an evaporation structure is used, the evaporation structure is typically made of ceramics or metal.

Further, the lifetime of the evaporation structure can be increased without losing any of the effects mentioned earlier. The whole bending fixture can be moved slowly and in a well defined course, wherein the movement can include a turning, so that the wire hits the evaporation structure not only in one point but on several well defined positions over time. Typically, the bending fixture is moved after a period of time has elapsed. In embodiments, the bending fixture includes a device for moving the bending fixture. The moving of the bending fixture can include a turning of the bending fixture.

If movement of the contact point on the evaporation structure is desired, e.g. by means of an electric motor, this can be also achieved by moving the at least one movable roller and fixing the at least one movable bearing at different positions. By doing this, the wire contacts the evaporation structure not only in one point but on several well defined positions over time. Typically, the at least one movable roller is moved after a period of time has elapsed. In this way, the lifetime of the evaporation structure can be increased without losing any of the effects mentioned earlier.

Figure 5A shows a three-dimensional view of the bending fixture according to the present disclosure. The wire is fed via the first opening 101 and exits the bending fixture at the exit, i.e. the second opening 103 that may be provided with a conduit 405.

In general, three rollers are fixed at constant positions. In the embodiment shown in Fig. 1-5B, the fixed rollers are referred to as numbers 407, 409, and 410. In Fig. 5A and 5B it is possible to recognize the fixing units 501 for fixing the rollers. Generally, the fixing units can be provided in all embodiments described herein. Typically, the fixing means are screws or the like. The fixing units may engage from the top of the bending fixture. Also, the fixing units may be embedded in the bending fixture as described below.

Further, the bending fixture of the present disclosure may generally have a slotted hole that typically includes a movement device such as a grub screw for moving and/or fixing the second roller. In the exemplary embodiment of Fig. 5A, it is possible to enter the slotted hole 500 with a screwdriver or an Allen wrench in order to turn the screw embedded within the hole. By turning the embedded screw, the second roller 408 is moved up or down, i.e. away from the entrance-exit line of the bending fixture or towards the entrance-exit line. For instance, the second roller may move on the roller moving device 113 that has been exemplarily illustrated in Fig. 1. Once the desired position is reached, the second roller might be fixed at this position by means of the fixing unit 501 such as a screw.

In embodiments, two slotted holes are provided each allowing a screwdriver or the like to enter the hole. For instance, the movable roller may be fixed by a pair of grub screws. One grub screw is accessible with a screwdriver or the like from one side of the bending fixture, the other one is accessible from the other side. By loosen one grub screw, the roller becomes movable in one direction. The other grub screw may be fastened in order to move the roller in this direction until the roller is clamped between the grub screws and thereby fixed at the desired position.

If the second roller is moved by means of an electric device such as an electronic motor, the driven axis of the electric motor is used to cooperate with the movement device. For instance, the electric motor might be connected to the movement device in order to provide for a constant movement. Thereby, the rotating movement of the motor is transferred to a linear movement of the roller. A constant movement as used herein typically includes a change of the movement direction. In other words, the second roller may be moved at a constant speed away from the entrance-exit line for a predefined time interval, followed by a movement with a constant speed in the opposite direction.

Embodiments having an electric drive are exemplarily illustrated in Fig. 5B. An electric motor 502 is coupled to the slotted hole 500 via the driven axis 503. The electric motor is normally controlled by means of a computing system such as a personal computer (not shown).

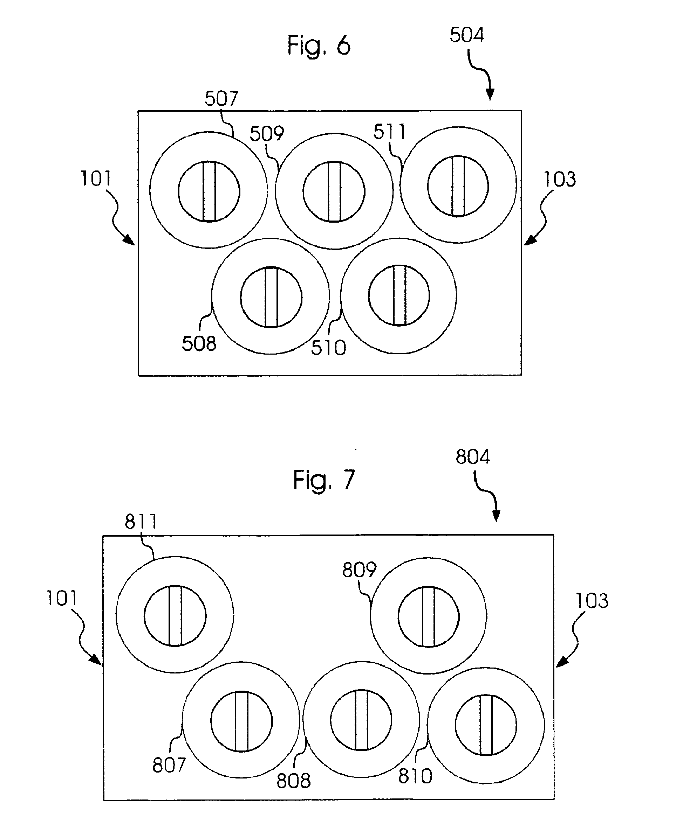

Figure 6 shows embodiments of the bending fixture 504. Typically, the wire is fed through the first opening 101 and exits the bending fixture 504 through the second opening 103. In some embodiments of the bending fixture, the multitude of rollers inside the bending fixture 504 consists of five rollers 507-511 situated in one plane alternately on two opposite sides of the fed wire.

In Figure 5, the rollers 507, 508, 509 and 510 are the four rollers that correspond to the four rollers 107, 108, 109, and 110 of Fig. 1.

Figure 7 shows embodiments of the bending fixture 804. Typically, the wire is fed through the first opening 101 and exits the bending fixture 804 through the second opening 103. In embodiments of the bending fixture the multitude of rollers inside the bending fixture consists of five rollers 807-811 situated in one plane on two opposite sides of the entrance-exit line.

In Figure 7, the rollers 811, 807, 809 and 810 are the four rollers that correspond to the four rollers 107, 108, 109, and 110 of Fig. 1.

According to further embodiments, an evaporation apparatus including a wire feed, an evaporation structure and at least one bending fixture for giving a wire a reproducible curvature are provided. The bending fixture is a bending fixture according to embodiments described herein.

The described bending fixture can be used in an evaporation method: the wire is fed into the bending fixture and the exiting wire is fed to a heated evaporation structure, where the fed wire melts and evaporates.

The wire used can consist of any flexible metal or alloy, for example aluminum, aluminum oxide, copper, silver, aluminum alloys etc. Typical wire diameters are in the range of between 0.5 mm and 3 mm such as between 1 mm and 2 mm.

While the foregoing is directed to embodiments of the invention, other and further embodiments of the invention may be devised without departing from the basic scope thereof, and the scope thereof is determined by the claims that follow.

## Claims

1. An evaporation apparatus for coating a substrate having
- an evaporation structure (412) for evaporating material, the evaporation structure having an evaporation structure surface for receiving a wire;
- a wire feed (450) for providing the wire;
- a bending fixture comprising a first and a second roller (107-108; 407-408; 807-808) for guiding the wire, wherein the second roller is movable with respect to the first roller, and wherein the bending fixture is capable of giving the wire (402) a reproducible curvature so that in operation of the evaporation apparatus the contact spot of the wire on the evaporation structure is at a desired position; and
- an electric motor (502) for moving the at least one movable roller (408) and/or an electric motor for moving the bending fixture.

2. The evaporation apparatus for coating a substrate according to claim 1, wherein the first and the second rollers are positioned such that, when a wire is fed through the bending fixture, the wire contacts the first roller and the second roller in sequence.

3. The evaporation apparatus for coating a substrate according to claim 1 or 2, further comprising a roller moving device (113) for allowing the second roller to move.

4. The evaporation apparatus for coating a substrate according to claim 3, wherein the second roller is moved in a direction perpendicular to the wire.

5. The evaporation apparatus for coating a substrate according to claim 1 or 3, further comprising
a third and a fourth roller (109-110; 409-410; 509-510; 809-810) for guiding the wire;
wherein the first and the third rollers are positioned on a first side of the wire; and
wherein the second and the fourth rollers are positioned on a second side of the wire, the second side of the wire being opposite to the first side;
the rollers being arranged such that, when a wire is fed through the bending fixture, the wire contacts the first roller, the second roller, the third roller, and the fourth roller in sequence.

6. The evaporation apparatus according to any of the preceding claims 3-5 wherein the roller moving device (113) comprises a fixing unit for fixing the movable roller at at least one position.

7. The evaporation apparatus according to any of the preceding claims 1-6, further comprising a guiding unit (405) for guiding the wire after contacting the rollers.

8. A method for evaporating a wire, the method comprising
- guiding the wire through a bending fixture thereby giving the wire a reproducible curvature so that the contact spot of the wire on the evaporation structure is at desired position, wherein the bending fixture comprises a first and a second roller (107-108; 407-408; 807-808) for guiding the wire, wherein the second roller is movable with respect to the first roller;
- directing the wire to an evaporation structure for evaporation;
- moving the movable second roller (108; 408; 508; 808) and/or the bending fixture (104; 404; 504; 804) by means of an electric motor such that the contact point of the wire (402) on the evaporation structure (412) changes steadily over time; and
- evaporating the wire.

9. The method for evaporating a wire according to claim 8, the method further comprising
- moving and fixing a movable second roller (108; 408; 508; 808) in the bending fixture in relation to a first roller, both rollers being positioned in the bending fixture; and
- guiding the wire through the first and second roller (107-110) in the bending fixture.

10. The method according to claim 8 or 9, further checking if the curvature radius of the exiting wire (402) has changed, and, depending on the outcome, moving and fixing the second roller (108; 408; 508; 808) in the bending fixture (104; 404; 504; 804) if the curvature radius of the exiting wire has changed.

11. The method according to any of claims 8-10, wherein the wire is made of an evaporable material (402) and is fed to an evaporation structure (412).

12. The method according to claim 11, wherein the movable roller is moved with a constant movement.

## Patentansprüche

1. Eine Verdampfungsvorrichtung zum Beschichten eines Substrates mit
- einer Verdampfungsstruktur (412) zum Verdampfen von Material, wobei die Verdampfungsstruktur eine Verdampfungsstrukturoberfläche zum Empfangen eines Drahtes aufweist;
- eine Drahtversorgung (450) zum zur Verfügung Stellen des Drahtes;
- eine Biegespanneinrichtung mit einer ersten und einer zweiten Rolle (107-108; 407-408; 807-808) zum Führen des Drahtes, wobei die zweite Rolle im Bezug auf die erste Rolle beweglich ist, und wobei die Biegespanneinrichtung in der Lage ist, dem Draht (402) eine reproduzierbare Krümmung zu geben, so dass während des Betriebs der Verdampfungsvorrichtung der Kontaktpunkt des Drahtes auf der Verdampfungsstruktur sich an einer gewünschten Position befindet; und
- einen elektrischen Motor (502) zum Bewegen der wenigstens einen beweglichen Rolle (408) und/oder einen elektrischen Motor zum Bewegen der Biegespanneinrichtung.

2. Die Verdampfungsvorrichtung zum Beschichten eines Substrates gemäß Anspruch 1, wobei die erste und die zweite Rolle derart positioniert sind, dass der Draht die erste Rolle und die zweite Rolle nacheinander berührt, wenn ein Draht durch die Biegespanneinrichtung gefördert wird.

3. Die Verdampfungsvorrichtung zum Beschichten eines Substrates gemäß Anspruch 1 oder 2, des Weiteren umfassend eine Rollenbewegungseinheit (113), um es der zweiten Rolle zu ermöglichen, sich zu bewegen.

4. Die Verdampfungsvorrichtung zum Beschichten eines Substrates gemäß Anspruch 3, wobei die zweite Rolle in einer Richtung bewegt wird, die senkrecht zu dem Draht ist.

5. Die Verdampfungsvorrichtung zum Beschichten eines Substrates gemäß Anspruch 1 oder 3, des Weiteren umfassend
eine dritte und vierte Rolle (109-110; 409-410; 509-510; 809-810) zum Führen des Drahtes;
wobei die erste und dritte Rolle auf einer ersten Seite des Drahtes positioniert sind; und
wobei die zweite und vierte Rolle auf einer zweiten Seiten des Drahtes positioniert sind, wobei die zweite Seite des Drahtes gegenüber der ersten Seite liegt; und wobei die Rollen derart angeordnet sind, dass der Draht nacheinander die erste Rolle, die zweite Rolle, die dritte Rolle, und die vierte Rolle berührt, wenn ein Draht durch die Biegespanneinrichtung befördert wird.

6. Die Verdampfungsvorrichtung gemäß einem der vorhergehenden Ansprüche 3-5, wobei die Rollenbewegungseinheit (113) eine Feststelleinheit zum Arretieren der beweglichen Rolle an wenigstens einer Position umfasst.

7. Die Verdampfungsvorrichtung gemäß einem der vorhergehenden Ansprüche 1-6, des Weiteren umfassend eine Führungseinheit (405) zum Führen des Drahtes nach dem Kontakt mit den Rollen.

8. Ein Verfahren zum Verdampfen von Draht, wobei das Verfahren umfasst
- Führen des Drahtes durch eine Biegespanneinrichtung, wobei dadurch dem Draht eine reproduzierbare Krümmung gegeben wird, so dass der Kontaktpunkt des Drahtes auf der Verdampfungsstruktur sich an einer gewünschten Position befindet, wobei die Biegespanneinrichtung eine erste und eine zweite Rolle (107-108; 407-408; 807-808) zum Führen des Drahtes umfasst, wobei die zweite Rolle im Bezug auf die erste Rolle beweglich ist;
- Richten des Drahtes auf eine Verdampfungsstruktur zur Verdampfung;
- Bewegen der beweglichen zweiten Rolle (108; 408; 508; 808) und/oder der Biegespanneinrichtung (104; 404; 504; 804) mittels einem elektrischen Motor, so dass der Kontaktpunkt des Drahtes (402) auf der Verdampfungsstruktur (412) sich über die Zeit hinweg gleichförmig verändert; und
- Verdampfen des Drahtes.

9. Das Verfahren zum Verdampfen eines Drahtes gemäß Anspruch 8, wobei das Verfahren des Weiteren umfasst
- Bewegen und Arretieren einer beweglichen zweiten Rolle (108; 408; 508; 808) in der Biegespanneinrichtung in Bezug zu einer ersten Rolle, wobei beide Rollen in der Biegespanneinrichtung positioniert sind, und
- Führen des Drahtes durch die erste und zweite Rolle (107-110) in der Biegespanneinrichtung.

10. Das Verfahren gemäß Anspruch 8 oder 9, darüber hinaus Überprüfen, ob sich der Krümmungsradius des herausgeführten Drahtes (402) verändert hat, und, je nach Ergebnis, Bewegen und Arretieren des zweiten Rollers (108; 408; 508; 808) in der Biegespanneinrichtung (104; 404; 504; 804), wenn sich der Krümmungsradius des herausgeführten Drahtes verändert hat.

11. Das Verfahren gemäß einem der Ansprüche 8-10, wobei der Draht aus einem verdampfbaren Material (402) gemacht ist und einer Verdampfungsstruktur (412) zugeführt wird.

12. Das Verfahren gemäß Anspruch 11, wobei die bewegliche Rolle mit einer konstanten Bewegung bewegt wird.

## Revendications

1. Appareil d'évaporation destiné à revêtir un substrat, comprenant
- une structure d'évaporation (412) destinée à évaporer du matériau, la structure d'évaporation présentant une surface de structure d'évaporation destinée à recevoir un fil ;
- une amenée de fil (450) destinée à fournir le fil ;
- un dispositif de flexion comprenant un premier et un deuxième galet (107-108 ; 407-408 ; 807-808) pour le guidage du fil, le deuxième galet étant mobile par rapport au premier galet, et le dispositif de flexion étant capable de donner au fil (402) une courbure reproductible de telle sorte que, en fonctionnement de l'appareil d'évaporation, le point de contact du fil sur la structure d'évaporation soit à une position désirée ; et
- un moteur électrique (502) destiné à déplacer l'au moins un galet mobile (408) et/ou un moteur électrique destiné à déplacer le dispositif de flexion.

2. L'appareil d'évaporation destiné à revêtir un substrat selon la revendication 1, dans lequel le premier et le deuxième galet sont positionnés de telle sorte que, quand un fil est amené à travers le dispositif de flexion, le fil soit en contact avec le premier galet et le deuxième galet en séquence.

3. L'appareil d'évaporation destiné à revêtir un substrat selon la revendication 1 ou 2, comprenant en outre un dispositif de déplacement de galet (113) destiné à permettre au deuxième galet de se déplacer.

4. L'appareil d'évaporation destiné à revêtir un substrat selon la revendication 3, dans lequel le deuxième galet est déplacé dans une direction perpendiculaire au fil.

5. L'appareil d'évaporation destiné à revêtir un substrat selon la revendication 1 ou 3, comprenant en outre
un troisième et un quatrième galet (109-110 ; 409-410 ; 509-510 ; 809-810) pour le guidage du fil ;
dans lequel le premier et le troisième galet sont positionnés d'un premier côté du fil ; et
dans lequel le deuxième et le quatrième galet sont positionnés d'un deuxième côté du fil, le deuxième côté du fil étant à l'opposé du premier côté ;
les galets étant disposés de telle sorte que, quand un fil est amené à travers le dispositif de flexion, le fil soit en contact avec le premier galet, le deuxième galet, le troisième galet, et le quatrième galet en séquence.

6. L'appareil d'évaporation selon l'une quelconque des précédentes revendications 3 à 5, dans lequel le dispositif de déplacement de galet (113) comprend une unité de fixation destinée à fixer le galet mobile à au moins une position.

7. L'appareil d'évaporation selon l'une quelconque des précédentes revendications 1 à 6, comprenant en outre une unité de guidage (405) destinée à guider le fil après la mise en contact avec les galets.

8. Procédé d'évaporation d'un fil, le procédé comprenant
- le guidage du fil à travers un dispositif de flexion donnant ainsi au fil une courbure reproductible de telle sorte que le point de contact du fil sur la structure d'évaporation soit à une position désirée, le dispositif de flexion comprenant un premier et un deuxième galet (107-108 ; 407-408 ; 807-808) pour le guidage du fil, le deuxième galet étant mobile par rapport au premier galet ;
- le fait de diriger le fil vers une structure d'évaporation pour l'évaporation ;
- le déplacement du deuxième galet mobile (108 ; 408 ; 508 ; 808) et/ou du dispositif de flexion (104 ; 404 ; 504 ; 804) au moyen d'un moteur électrique de telle sorte que le point de contact du fil (402) sur la structure d'évaporation (412) change constamment au cours du temps ; et
- l'évaporation du fil.

9. Le procédé d'évaporation d'un fil selon la revendication 8, le procédé comprenant en outre
- le déplacement et la fixation d'un deuxième galet mobile (108 ; 408 ; 508 ; 808) dans le dispositif de flexion par rapport à un premier galet, les deux galets étant positionnés dans le dispositif de flexion ; et
- le guidage du fil à travers le premier et le deuxième galet (107-110) dans le dispositif de flexion.

10. Le procédé selon la revendication 8 ou 9, contrôlant en outre si le rayon de courbure du fil sortant (402) a changé, et, selon le résultat, déplaçant et fixant le deuxième galet (108 ; 408 ; 508 ; 808) dans le dispositif de flexion (104 ; 404 ; 504 ; 804) si le rayon de courbure du fil sortant a changé.

11. Le procédé selon l'une quelconque des revendications 8 à 10, dans lequel le fil est constitué d'un matériau évaporable (402) et est amené vers une structure d'évaporation (412).

12. Le procédé selon la revendication 11, dans lequel le galet mobile est déplacé en un mouvement constant.
